# EUROPÄISCHE PATENTSCHRIFT

(11) **EP 3 620 036 B1**
(45) Veröffentlichungstag und Bekanntmachung des Hinweises auf die Patenterteilung: **28.12.2022**
(21) Anmeldenummer: 18719863.5
(22) Anmeldetag: 24.04.2018
(51) Int. Cl.: H05K 5/00

(54) **ELEKTRONIKMODUL**
ELECTRONIC MODULE
MODULE ÉLECTRONIQUE

(30) Priorität: 04.05.2017 DE 102017207491
(43) Veröffentlichungstag der Anmeldung: 11.03.2020
(73) Patentinhaber: Bayerische Motoren Werke Aktiengesellschaft, 80809 München (DE)
(72) Erfinder: KALTENBRUNNER, Martin, 84416 Taufkirchen (Vils) (DE); DUSS, Mike, 76359 Karlsruhe (DE)
(86) Internationale Anmeldenummer: PCT/EP2018/060452
(87) Internationale Veröffentlichungsnummer: WO 2018/202478

(56) Entgegenhaltungen:
- WO-A1-2012/089971
- WO-A1-2015/185307
- WO-A2-2009/013694
- DE-A1-102011 088 279
- DE-A1-102011 121 823
- DE-A1-102013 215 227
- DE-A1-102015 214 311
- DE-A1-102015 217 802

## Beschreibung

Die vorliegende Erfindung betrifft ein Elektronikmodul, ein Steuergerät, ein Verfahren zum Befestigen einer Leiterplatte sowie eine Verwendung von Leiterplattenlack.

Elektronikmodule der in Rede stehenden Art werden unter anderem zum Erfassen, Verarbeiten und/oder Ausgeben von Signalen und Daten eingesetzt. Beispielsweise werden Elektronikmodule in Kraftfahrzeugen in Form von Steuergeräten verwendet, um die verschiedensten Fahrzeugfunktionen zu koordinieren und bereitzustellen. Derartige Elektronikmodule/Steuergeräte weisen eine Vielzahl von Bauelementen auf, wie z. B. elektrische Widerstände, Spulen, Kondensatoren, integrierte Schaltungen (ICs), verschiedene Arten von Sensoren, Aktuatoren und Steckern etc., die auf einem Substrat mechanisch gehalten und überdies untereinander elektrisch verschaltet sind. Das Substrat ist in der Regel eine Leiterplatte (auch als Platine oder PCB, printed circuit board, bezeichnet). Auf oder in der Leiterplatte können Leiterbahnen zum Verschalten der Bauelemente vorgesehen sein. Alternativ können die Bauelemente beispielsweise an Stanzgittern angeordnet und mit deren Hilfe verschaltet sein. Problematisch ist in diesem Zusammenhang, dass es sich bei derartigen Leiterplatten um extrem diffizile Bauteile handelt und Störungen bzw. Schäden schnell zum Ausfall des gesamten Fahrzeugs führen können. Insbesondere mechanische Lasten, welche darin resultieren, dass die Leiterplatte beispielsweise verbiegt, sind unbedingt zu vermeiden, da die zulässigen Spannungen in der Leiterplatte äußerst gering sind. Oftmals werden bereits beim Einbau der Leiterplatte in das entsprechende Gehäuse des Steuergeräts, beispielsweise durch ein Verspannen oder Verbiegen der Leiterplatte, die zulässigen Grenzwerte überschritten. Auch wenn beispielsweise Stecker am Gehäuse des Steuergeräts angebracht werden, kann der hierbei aufgebrachte Druck zu einem Verbiegen und in der Folge auch zu einem Beschädigen der Leiterplatte führen.

Die DE 10 2011 088 279 A1 betrifft eine elektronische Vorrichtung, die erhalten wird durch Verbinden eines Verbinders mit einem Verdrahtungssubstrat, das an oder in einem Gehäuse angeordnet ist, sowie ein Verfahren zur Herstellung einer derartigen elektronischen Vorrichtung.

Die DE 10 2013 215 227 A1 betrifft ein Elektronikmodul, wie es insbesondere für ein Getriebesteuermodul in einem Kraftfahrzeug eingesetzt werden kann. Insbesondere wird ein Elektronikmodul beschrieben, bei dem elektronische Bauteile langfristig hermetisch dicht gegenüber aggressiven umgebenden Medien geschützt sind. Dabei weist das Elektronikmodul eine Leiterplatte, eine Modulbodenplatte, einen Dichtring und eine Flexfolie auf.

Die DE 10 2011 121 823 A1 betrifft eine Elektronikeinheit mit einem eine Gehäusebasis und einen Deckel aufweisenden Gehäuse, in dessen Hohlraum eine elektronische Bauteile tragende Leiterplatte angeordnet ist. Zur Ableitung von beim Betrieb dieser Elektronikeinheit entstehender Abwärme ist vorgesehen, dass die Leiterplatte an ihrer zur Gehäusebasis weisenden Seite mit einem doppelseitigen klebenden sowie elektrisch isolierenden Klebestreifen verbunden ist, und dass die leiterplattenferne Seite des Klebestreifens mit der Innenseite der Gehäusebasis verbunden ist.

Die WO 2015/185307 A1 betrifft ein Mittel zur Befestigung einer Leiterplatte an einer Innenwand eines Verteilerkastens oder einer Trägerplatte. Zur einfachen und schnellen Anordnung der Leiterplatte an der Innenwand des Verteilerkastens umfasst das Mittel einen auf zumindest einer Komponente basierenden Klebstoff.

Die WO 2012/089971 A1 betrifft eine Anordnung aus einer Platte einer elektronischen Schaltung und einem Träger der Platte, wobei die Platte und der Träger zwei einander gegenüber und in gegenseitigem Kontakt befindliche Oberflächen, die Kontaktoberflächen genannt werden, aufweist und wobei die Anordnung außerdem ein aufgetragenes Material umfasst, das in Form von Klebepunkten verteilt ist und ermöglicht, eine Verankerung durch Kleben der Platte an dem Träger zu verwirklichen, wobei die Platte mit wenigstens einer Durchgangsöffnung, die Befestigungsöffnung genannt wird, versehen ist, und die Kontaktfläche des Trägers vertieft verwirklichte Eindrücke am Ort der Befestigungsöffnungen aufweist, wobei das Material durch die Befestigungsöffnung verläuft, derart, dass es mit dem Träger und mit der Platte in Kontakt gelangt.

Die DE 10 2015 214 311 A1 betrifft ein Elektronikmodul, wie es beispielsweise als Getriebesteuermodul für ein Kraftfahrzeug eingesetzt werden kann. Bauelemente, wie insbesondere Sensoren oder Stecker sind hierbei zuverlässig und langfristig stabil an einer Leiterplatte befestigbar. Das Elektronikmodul weist hierzu ein in eine Schutzmasse eingebettetes Sockelelement auf.

Die DE 10 2015 217 802 A1 betrifft eine elektronische Baugruppe mit einer Grundleiterplatte mit einer ersten Seite und einer von der ersten Seite abgewandten zweiten Seite und eine flexible Leiterplatte, die eine der zweiten Seite der Grundleiterplatte zugewandte Kontaktseite aufweist, wobei die Kontaktseite der flexiblen Leiterplatte zumindest abschnittsweise von der Grundleiterplatte durch wenigstens einen Zwischenraum beabstandet ist und wobei die Grundleiterplatte wenigstens eine Leiterbahn aufweist und die flexible Leiterplatte wenigstens eine weitere Leiterbahn aufweist und auf der zweiten Seite der Grundleiterplatte eine elektrisch mit der wenigstens einen Leiterbahn verbundene Kontaktierungsstelle ausgebildet ist, und auf der Kontaktseite der flexiblen Leiterplatte eine elektrisch mit der wenigstens einen weiteren Leiterbahn verbundene weitere Kontaktierungsstelle ausgebildet ist und die weitere Kontaktierungsstelle auf der Kontaktseite der flexiblen Leiterplatte durch ein in dem Zwischenraum angeordnetes Verbindungsmittel, dass elektrisch leitfähig ist, mit der Kontaktierungsstelle auf der zweiten Seite der Grundleiterplatte elektrisch leitend verbunden ist.

Die WO 2009/013694 A2 (Dokument D8) offenbart ein elektronisches Gerät mit einer flexiblen Leiterplatte, welche gebogen in einer Einhausung angeordnet ist.

Es ist daher eine Aufgabe der vorliegenden Erfindung, ein Elektronikmodul, ein Steuergerät, ein Verfahren zum Befestigen einer Leiterplatte sowie eine Verwendung von Leiterplattenlack anzugeben, welche die vorgenannten Nachteile beseitigen und dabei insbesondere eine einfache und kostengünstige Lösung darstellen.

Diese Aufgabe wird durch ein Elektronikmodul gemäß Anspruch 1, ein Steuergerät gemäß Anspruch 10, ein Verfahren gemäß Anspruch 11 sowie durch eine Verwendung gemäß Anspruch 13 gelöst. Weitere Vorteile und Merkmale ergeben sich aus den Unteransprüchen sowie der Beschreibung und den beigefügten Figuren.

Erfindungsgemäß umfasst ein Elektronikmodul ein Tragelement und eine Leiterplatte, wobei die Leiterplatte über zumindest eine Verbindungsstelle in und/oder an dem Tragelement befestigt ist, und wobei die zumindest eine Verbindungsstelle durch ein aushärtbares Medium gebildet ist. Bevorzugt wird durch die zumindest eine Verbindungsstelle eine stoffschlüssige Verbindung realisiert. Insbesondere ist die Leiterplatte spannungsfrei in und/oder an dem Tragelement befestigt. Erfindungsgemäß ist eine Vielzahl von Verbindungsstellen vorgesehen. Zweckmäßigerweise handelt es sich bei dem Medium um ein Medium, welches zwei Zustände umfasst, nämlich einen flüssigen Zustand und einen festen Zustand, also einen Zustand, in welchem das Medium ausgehärtet ist. Zweckmäßigerweise ist es dadurch möglich, eine Dimensionierung bzw. insbesondere z. B. eine Höhe der Verbindungsstellen durch die Anordnung des Tragelements und der Leiterplatte zueinander einzustellen. Das Medium wird vorteilhafterweise im flüssigen Zustand aufgebracht und kann sich daher den Formen des Tragelements bzw. der Leiterplatte anpassen. Mit anderen Worten geben die Verbindungsstellen also nicht eine Lage bzw. Positionierung der beiden vorgenannten Bauteile zueinander vor, sondern die Form und Lage der Leiterplatte bzw. des Tragelements, insbesondere zueinander, bestimmen Form und Lage der Verbindungsstelle(n). Dadurch wird ermöglicht, dass das Tragelement die Leiterplatte in idealer Weise stützt, insbesondere ohne dass bei diesem Befestigungsvorgang die Form der Leiterplatte verändert wird oder Lasten aufgebracht werden. Die Leiterplatte wird also nicht verspannt, wie es beispielsweise im Stand der Technik der Fall ist, wenn eine Leiterplatte an einem Tragelement über Schraubverbindungen oder festsitzende form- und kraftschlüssige Verbindungen befestigt wird. Vorliegend ist allerdings nicht ausgeschlossen, dass das Tragelement und die Leiterplatte auch über form-und/oder kraftschlüssige Verbindungen, insbesondere auch in Form von Schraubverbindungen, aneinander befestigt sind. Diese sind aber vorteilhafterweise derart ausgelegt und positioniert, dass die Leiterplatte nicht verspannt wird. Gemäß einer Ausführungsform ist die Leiterplatte z. B. nur an einer oder zwei Stellen über eine Schraubverbindung gehalten. Die vorliegende Leiterplatte, auch als Platine oder PCB (printed circuit board) bezeichnet, umfasst gemäß verschiedenen Ausführungsformen zumindest einen oder mehrere Elektronikbausteine, wie beispielsweise Prozessoren, elektrische Widerstände, Spulen, Kondensatoren, integrierte Schaltungen (ICs), verschiedene Arten von Sensoren, Aktuatoren und Stecker etc., wobei die Elektronikbausteine auf der Leiterplatte bevorzugt mechanisch gehalten und überdies untereinander elektrisch verschaltet sind. Hierzu sind auf und/oder in oder an der Leiterplatte Leiterbahnen vorgesehen. In der Regel sind derartige Leiterplatten nie vollständig plan bzw. eben sondern weisen, z. B. auf eine Länge von etwa 20 cm, einen Höhenversatz von zumindest einigen Mikrometern auf. Diese an sich geringe Abweichung bezüglich der Ebenheit kann beim Festschrauben der Leiterplatte bereits dazu führen, dass zulässige Biegespannungen überschritten werden. Hierdurch besteht das Risiko von Reibkorrosion an Steckerkontakten, des Brechens von Leiterbahnen und des Ausfalls von Prozessoren etc. Dadurch dass die Verbindungsstellen aber aus dem aushärtbaren Medium gebildet sind, kommt es bei der Befestigung der Leiterplatte an dem Tragelement zu keinerlei Verspannungen. Außerdem ist die Leiterplatte in idealer Weise abgestützt.

Erfindungsgemäß füllt/füllen die Verbindungsstelle(n) Lücken, Spalte und/oder Hinterschneidungen zwischen dem Tragelement und der Leiterplatte bzw. schließt/schließen diese. Insbesondere sind also die Verbindungsstellen hinsichtlich Form und/oder Lage an die Leiterplatte derart angepasst, dass eine spannungsfreie Befestigung der Leiterplatte ermöglicht ist.

Gemäß einer Ausführungsform und nicht erfindungsgemäß ist das aushärtbare Medium beispielsweise ein Klebstoff, bevorzugt ein Klebstoff, welcher in einem ersten Zustand flüssig, insbesondere dünnflüssig, ist. Ein derartiger Klebstoff kann an verschiedene Stellen der Leiterplatte und/oder des Tragelements aufgebracht werden. In einem nächsten Schritt werden dann das Tragelement und die Leiterplatte aneinander angeordnet und die Verbindungsstellen formen sich mit Vorteil an den Stellen, an denen sich das Tragelement und die Leiterplatte nahe kommen oder ggf. auch berühren. Nach Aushärten der Verbindungsstellen sind das Tragelement und die Leiterplatte aneinander befestigt, wobei diese Befestigung insbesondere spannungsfrei erfolgt ist.

Erfindungsgemäß ist das aushärtbare Medium ein Leiterplattenlack. Im Stand der Technik dient der Leiterplattenlack primär dem Schutz der Elektronickomponenten/Elektronikbausteine auf der Leiterplatte vor Feuchtigkeit und Wassereintrag. Vorliegend wird nun in idealer Weise der ohnehin nötige Leiterplattenlack zusätzlich zur Verbindung bzw. Befestigung und auch Versteifung der Leiterplatte verwendet. Dies wird insbesondere dadurch ermöglicht, dass der Leiterplattenlack die Verbindungsstellen formt. Zweckmäßigerweise ist die Leiterplatte vollflächig bzw. vollständig mit dem Leiterplattenlack umgeben bzw. benetzt, wobei dies beispielsweise durch ein Eintauchen, und zweckmäßigerweise anschließendes Abtropfen-Lassen, der Leiterplatte in den zunächst flüssigen Leiterplattenlack erfolgt. Die Auswahl des Leiterplattenlacks ist vorliegend nicht kritisch. Es kann sich, je nach Anforderung, um silikonhaltigen oder um silikonfreien Leiterplattenlack handeln. Der Leiterplattenlack kann auch durch Sprühen aufgetragen werden. So ist es grundsätzlich möglich, zuerst den Leiterplattenlack auf der Leiterplatte anzubringen und dann das Tragelement anzuordnen. Auch das Tragelement kann mit Leiterplattenlack (oder mit Klebstoff) benetzt werden. Bevorzugt erfolgt eine Anordnung der Leiterplatte an dem Tragelement und im Anschluss ein gemeinsames Eintauchen bis zu einer gewissen Eintauchtiefe, welche sicherstellt, dass die Elektronikbausteine bzw. die Leiterplatte als solche ausreichend mit dem Leiterplattenlack benetzt sind. Hierbei werden mit Vorteil auch Bereiche des Tragelements mit dem Leiterplattenlack benetzt, sodass sozusagen "automatisch", nach dem Aushärten des Mediums/Leiterplattenlacks, Verbindungsstellen gebildet werden. Der Auftrag des Mediums/Leiterplattenlacks erfolgt dabei vorteilhafterweise dünn, beispielsweise mit einer Schichtdicke von max. bis zu 1 mm, bevorzugt weniger.

Bevorzugterweise sind also die Verbindungsstellen durch ein zumindest bereichsweises Eintauchen der Leiterplatte und des Tragelements in das aushärtbare Medium geformt bzw. gebildet.

Zweckmäßigerweise ist die Leiterplatte in und/oder an das Tragelement formschlüssig angeordnet oder anordenbar, insbesondere an- oder einsteckbar. Die Anordnung kann hier auch relative "lose" ausgebildet sein, da die eigentliche Befestigung über das aushärtbare Medium realisiert wird. Die lose Anordnung bringt den Vorteil mit sich, dass keine (Biege-)Spannungen induziert werden.

Zweckmäßigerweise weist das Tragelement zumindest ein Hakenelement auf, welches zur form- und/oder kraftschlüssigen Verbindung an der Leiterplatte ausgelegt ist, wobei im Bereich der form- und/oder kraftschlüssigen Verbindung zumindest eine Verbindungsstelle vorgesehen ist. Derartige Haken- oder Schnappverbindungen sind aus dem Stand der Technik grundsätzlich bekannt. Problematisch dabei ist, dass diese Art der Verbindung keine sichere Kraft- und/oder Formschlüssigkeit garantiert. Eine derart "befestigte" Leiterplatte kann sich beim Anbringen eines Steckers an dem entsprechenden Steuergerät leicht verbiegen. Hierdurch besteht z. B. das Risiko von Reibkorrosion an Steckerkontakten, des Brechens von Leiterbahnen, des Ausfalls von Prozessoren etc. Mit Vorteil sind nun aber im Bereich dieser Hakenelemente bzw. Haken- oder Schnappverbindungen zusätzlich die Verbindungsstellen aus dem aushärtbaren Material vorgesehen, welche ausgelegt sind, die vorgenannten form- und/oder kraftschlüssigen Verbindungen zu fixieren. Insbesondere ist also zusätzlich noch ein Stoffschluss aufgebaut, welcher die Form- und Kraftschlüssigkeit, auch über die Lebenszeit des Produkts, sicherstellt. Dadurch dass das aushärtbare Medium im ersten Zustand flüssig ist, kann es in etwaige Lücken, Spalte, Hinterschneidungen etc. der Haken- und Schnappverbindungselemente einfließen und diese nach dem Aushärten fixieren.

Gemäß einer Ausführungsform weisen das Tragelement und/oder die Leiterplatte auch Zusatzelemente auf, welche sich beispielsweise quer oder schräg zu einer Leiterplattenebene erstrecken und zusätzliche Hinterschneidungen, Lücken oder Spalte formen, in die das aushärtbare Medium einfließen kann, um sozusagen zusätzliche "Klebeflächen" bereitzustellen.

Gemäß einer Ausführungsform umfasst die Leiterplatte zumindest einen Elektronikbaustein, insbesondere einen Pin-Block, wobei zumindest eine Verbindungsstelle an dem zumindest einen Elektronikbaustein, insbesondere am Pin-Block, ausgebildet ist. Zweckmäßigerweise umfasst das Tragelement einen entsprechenden Kragenanschluss, welcher zur formschlüssigen Anordnung an dem Pin-Block ausgelegt ist. Der Pin-Block ist z. B. auf der Leiterplatte verlötet und weist eine Vielzahl von Pins auf, welche sich quer zu der Leiterplattenebene erstrecken. An diesen Pins kann beispielsweise ein geeigneter Stecker angeordnet/angeschlossen werden. Beim Anordnen des Steckers wirkt eine Druckkraft auf die Leiterplatte, welche zu dessen Verbiegen und in der Folge zur Überschreitung zulässiger Biegespannungswerte bzw. Oberflächenspannungen führen kann. Mit Vorteil ist aber nun im Bereich des Pin-Blocks zumindest eine Verbindungsstelle ausgebildet, welche den Pin-Block mit dem Tragelement bzw. mit einem Kragenanschluss des Tragelements stoffschlüssig verbindet. Insofern kann in idealer Weise die Steifigkeit bzw. Festigkeit des Tragelements auf die Leiterplatte übertragen werden. Bei Anordnung des vorgenannten Steckers kommt es dadurch nicht zu einem Verbiegen der Leiterplatte, da diese in idealer Weise durch das Tragelement gestützt ist.

Zweckmäßigerweise entsprechen die Außenabmessungen des Tragelements, projiziert auf die Leiterplattenebene, im Wesentlichen den Außenabmessungen der Leiterplatte. Zweckmäßigerweise ist das Tragelement derart ausgebildet bzw. gestaltet, dass es die Leiterplatte überragt oder umschließt, mit anderen Worten ist die Leiterplatte in das Tragelement mit Vorteil eingebettet. Zweckmäßigerweise ist sichergestellt, dass das Tragelement die Leiterplatte möglichst gut stützt. Die Verbindungsstellen sind hierbei so (verteilt) angeordnet, dass die Festigkeit/Steifigkeit des Tragelements bestmöglich auf die Leiterplatte übertragen werden kann bzw. sich diese bestmöglich an dem Tragelement abstützen kann.

Zweckmäßigerweise sind die Verbindungsstellen am Tragelement verteilt, insbesondere im Wesentlichen regelmäßig oder gleichmäßig verteilt, angeordnet. Dies bedeutet, dass sowohl in den Randbereichen als auch im Mittelbereich des Tragelements Verbindungsstellen vorgesehen sind, da dadurch eine vollflächige Abstützung der Leiterplatte gewährleistet werden kann. Gemäß einer Ausführungsform ist eine Vielzahl von Verbindungsstellen in Form eines matrixförmigen Rasters ausgebildet. Oftmals sind die Verbindungsstellen aber eher unregelmäßig verteilt, da sich deren Anzahl, Lage und Position insbesondere aus der Geometrie der Leiterplatte und des Tragelements ergeben.

Gemäß einer bevorzugten Ausführungsform ist das Tragelement ein Gehäuse oder ein Gehäuseteil des Elektronikmoduls, insbesondere ein Außengehäuse. Bei dem Elektronikmodul handelt es sich gemäß einer bevorzugten Ausführungsform um ein Haupt- oder Zentralsteuergerät eines Kraftfahrzeugs, insbesondere eines Pkw. Derartige Steuergeräte werden beispielsweise im Bereich des Innenraums der Fahrzeuge angeordnet. Die Gehäuse oder Gehäuseteile sind hierzu aus einem geeigneten Kunststoffwerkstoff gefertigt. Insbesondere handelt es sich bei dem Tragelement z. B. um eine Gehäuseschale eines zweiteiligen Gehäuses, beispielsweise um eine obere oder eine untere Gehäuseschale.

Gemäß einer Ausführungsform weist das Gehäuse oder das Gehäuseteil zumindest eine Anschlussbuchse auf bzw. formt diese oder bildet diese aus. Die Anschlussbuchse dient der Anordnung eines geeigneten Steckers, welcher dazu vorgesehen ist, eine elektrische Verbindung, beispielsweise mit dem vorgenannten Pin-Block, herzustellen. Der vorgenannte Kragenanschluss korrespondiert zweckmäßigerweise mit der gerade erwähnten Anschlussbuchse dahingehend, dass das Gehäuse an seiner Außenseite die Anschlussbuchse formt und an seiner korrespondierenden Innenseite den vorgenannten Kragenanschluss, welcher insbesondere zur formschlüssigen Anordnung an dem Pin-Block ausgelegt ist. Zweckmäßigerweise kann das Tragelement bzw. das Gehäuse eine Vielzahl derartiger Anschlussbuchsen umfassen, welche sich auch hinsichtlich der Größe unterscheiden können. Das gleiche gilt für die vorerwähnten Pin-Blöcke etc.

Gemäß einer Ausführungsform weist das Tragelement bzw. das Gehäuse oder das Gehäuseteil eine Versteifungsstruktur auf, wobei die Versteifungsstruktur Streben, Stege und/oder Waben etc. umfasst, welche sich im Wesentlichen senkrecht zu der Leiterplattenebene erstrecken. Bevorzugt sind derartige Versteifungsstrukturen an der Innenseite des Tragelements, zur Leiterplatte hin gewandt, ausgebildet. Typische Wandstärken des Tragelements bzw. des Gehäuses oder der Gehäuseteile liegen in einem Bereich von etwa 1-3 mm. Die Gehäuseteile sind bevorzugt form- und/oder kraftschlüssig verbunden, wobei hierbei Schnapp- und Hakenelemente zum Einsatz kommen können. Gegebenenfalls sind die Gehäuseteile auch (zusätzlich) miteinander verschraubt. Zudem können zur Befestigung der Gehäuseteile aneinander auch die Verbindungsstellen aus dem aushärtbaren Material vorgesehen sein.

Die Erfindung betrifft auch ein Steuergerät, insbesondere ein Hauptsteuergerät eines Kraftfahrzeugs, ausgebildet als ein erfindungsgemäßes Elektronikmodul, umfassend ein Gehäuse und eine darin angeordnete Leiterplatte, wobei das Gehäuse das Tragelement ist. Die Leiterplatte ist über zumindest eine Verbindungsstelle in und/oder an dem Gehäuse befestigt ist, und wobei die zumindest eine Verbindungsstelle durch Leiterplattenlack gebildet ist. Insbesondere handelt es sich bei dem Steuergerät um ein Zentral- bzw. Hauptsteuergerät eines Kraftfahrzeugs, wobei in dessen, bevorzugt zweiteiligen, Gehäuse die Leiterplatte angeordnet ist.

Die Erfindung betrifft weiter ein Verfahren zum Befestigen einer Leiterplatte an einem Tragelement, insbesondere einem Gehäuse oder Gehäuseteil, umfassend die Schritte:
- Bereitstellen einer Leiterplatte und eines Tragelements;
- Befestigen der Leiterplatte am Tragelement durch eine Vielzahl von Verbindungsstellen und Ausbilden der Verbindungsstellen durch Aufbringen eines aushärtbaren Mediums.

Zweckmäßigerweise umfasst das Verfahren weiter den Schritt:
- Anordnen, insbesondere spannungsfreies Anordnen, der Leiterplatte in und/oder an dem Tragelement;
- Eintauchen der Leiterplatte in das aushärtbare Medium.

Insofern erfolgt das Aufbringen des aushärtbaren Mediums durch ein Eintauchen der Leiterplatte, und zumindest bereichsweise auch des Tragelements, in das aushärtbare Medium, wobei es sich bei dem aushärtbaren Medium bevorzugt um Leiterplattenlack handelt. Alternativ können auch die Leiterplatte und/oder das Tragelement mit dem Medium/Leiterplattenlack etc. besprüht werden, wobei der Auftrag grundsätzlich auch dann erfolgen kann, wenn die Leiterplatte und das Tragelement noch nicht aneinander angeordnet sind. Da in der Regel der Auftrag von Leiterplattenlack ohnehin durch ein Eintauchen der Leiterplatte realisiert wird, ist es besonders vorteilhaft, wenn im Rahmen dieses Prozessschrittes auch gleichzeitig die Verbindungsstellen geformt werden.

Zweckmäßigerweise wird die Leiterplatte nach dem Auftrag des Mediums/des Leiterplattenlacks auch bewegt, beispielsweise verschwenkt, damit der (noch) dünnflüssige Lack (bzw. allgemein das Medium) in etwaige Zwischenräume, Lücken etc. zwischen der Leiterplatte und dem Tragelement fließen kann, um dort, nach dem Aushärten, Verbindungsstellen zu formen.

Die Erfindung betrifft auch eine Verwendung von Leiterplattenlack zum Versteifen bzw. Befestigen einer Leiterplatte an einem Tragelement, insbesondere einem Gehäuse eines Steuergeräts, wobei die Leiterplatte über eine Vielzahl von Verbindungsstellen in und/oder an dem Tragelement befestigt ist, wobei die Verbindungsstellen Lücken/Spalte/Hinterschneidungen zwischen dem Tragelement und der Leiterplatte ausfüllen oder schließen, und wobei die Verbindungsstellen durch den Leiterplattenlack gebildet sind.

Für das erfindungsgemäße Steuergerät, das erfindungsgemäße Verfahren sowie für die erfindungsgemäße Verwendung gelten die im Zusammenhang mit dem Elektronikmodul erwähnten Vorteile und Merkmale analog und entsprechend sowie umgekehrt und untereinander.

Weitere Vorteile und Merkmale ergeben sich aus der nachfolgenden Beschreibung einer Ausführungsform eines Elektronikmoduls sowie entsprechender Detailansichten.

Es zeigen:
- Fig. 1:: eine perspektivische Ansicht eines Steuergeräts in einer Schnittdarstellung;
- Fig. 2:: eine Detailansicht eines Anschlussbereichs des Steuergeräts der Figur 1;
- Fig. 3:: eine weitere Detailansicht eines Anschlussbereichs des Steuergeräts der Figur 1.

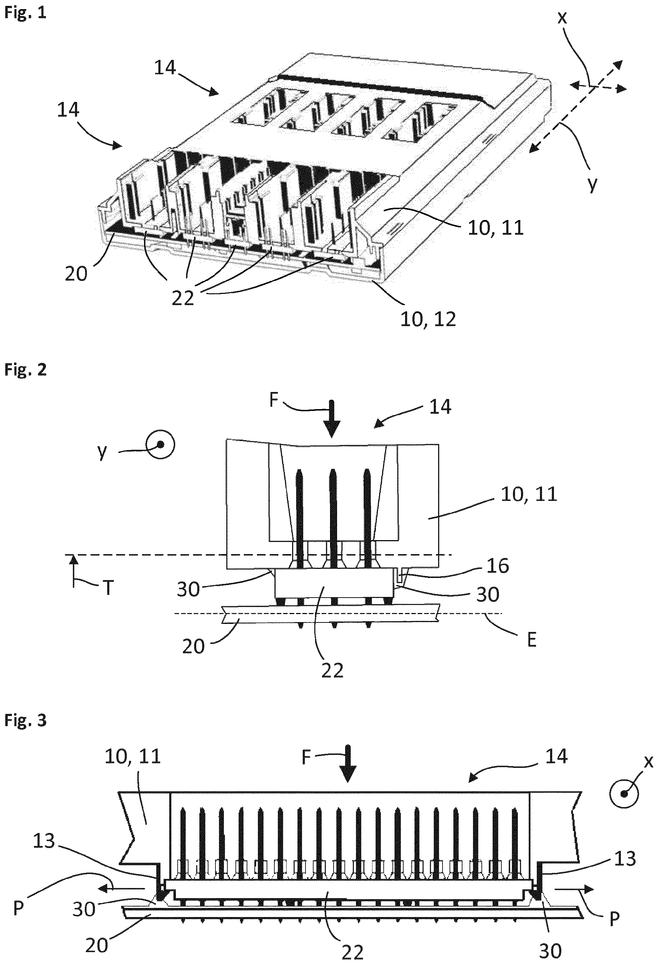

**Fig. 1** zeigt in einer perspektivischen Darstellung ein Elektronikmodul, umfassen zwei Tragelemente 10. Das dargestellte Elektronikmodul ist beispielsweise ein Haupt- bzw. Zentralsteuergerät eines Kraftfahrzeugs, beispielsweise eines Pkw, wobei die beiden Tragelemente 10 ein Gehäuse des Steuergeräts formen. Das Gehäuse umfasst insbesondere ein Gehäuseoberteil 11 und ein Gehäuseunterteil 12, wobei dazwischenliegend eine Leiterplatte 20 angeordnet ist. Das Gehäuseoberteil 11 umfasst eine Vielzahl von Anschlussbuchsen 14, welche der Anordnung entsprechender (hier nicht gezeigter) Stecker dienen. Durch den Schnitt ist eine Vielzahl von Pin-Blöcken 22 im Inneren des Steuergeräts erkennbar, welche auf die Leiterplatte 20 gelötet sind. Die Pins der Pin-Blöcke 22 ragen in die Anschlussbuchsen 14 hinein. Die gestrichelten Pfeile x und y signalisieren Richtungen, welche dem besseren Verständnis der Figuren 2 und 3 dienen.

**Fig. 2** zeigt in einem Schnitt entlang der x-Richtung einen Blick auf die Leiterplatte 20, welche eine Leiterplattenebene E definiert. Auf der Leiterplatte 20 ist ein Pin-Block 22 angeordnet, beispielsweise angelötet. Darüber ist das Gehäuseoberteil 11 bzw. ein Tragelement 10 angeordnet bzw. aufgesetzt. Insbesondere kann der hier zu sehende Bereich als Kragenanschluss bezeichnet werden, welcher eine Verbindung des Gehäuseoberteils 11 an die Leiterplatte 20 mittels des Pin-Blocks 22 ermöglicht. Mit den Bezugszeichen 30 sind Verbindungsstellen skizziert, welche aus einem aushärtbaren Medium gebildet sind. Erfindungsgemäß handelt es sich bei dem vorgenannten Medium um Leiterplattenlack. Ein Zusatzelement 16, welches sich von dem Kragenanschluss bzw. dem Gehäuseoberteil 11 weg erstreckt, formt zusammen mit dem Pin-Block 22 einen zusätzlichen Spalt bzw. eine zusätzliche Hinterschneidung, in welche das aushärtbare Medium, insbesondere der Leiterplattenlack, hineinfließen kann. Mit dem Bezugszeichen T ist eine mögliche Eintauchtiefe skizziert. Dies bedeutet, dass beispielsweise das Gehäuseoberteil 11 zusammen mit der Leiterplatte 20 in einen Behälter mit Leiterplattenlack bis zu dieser Höhe eingetaucht wird, um zum einen den Leiterplattenlack auf die Leiterplatte 20 aufzubringen und zum anderen, um die Verbindungsstellen 30, quasi automatisch, mit zu formen. Die Verbindungsstellen 30 bewirken einen Stoffschluss zwischen dem Tragelement 10, in Form des Gehäuseoberteils 11, und der Leiterplatte 20, wodurch eine Festigkeit bzw. Steifigkeit des Gehäuseoberteils 11 auf die Leiterplatte 20 übertragen werden kann. Wird ein Stecker in die Anschlussbuchse 14 gesteckt, wirkt eine Kraft entlang einer Kraftrichtung F, wie in der Fig. 2 skizziert. Diese (Druck-)Kraft könnte zu einem Verbiegen der Leiterplatte 20 führen. Die Verbindungsstellen 30 stellen aber sicher, dass die Steifigkeit des Gehäuseoberteils 11 derart auf die Leiterplatte 20 übertragen wird, dass ein derartiges Verbiegen nicht auftritt.

**Fig. 3** zeigt mit Bezug auf die Fig. 1 einen Schnitt entlang der y-Richtung. Auch hier ist ein Pin-Block 22 erkennbar, welcher an der Leiterplatte 20 angeordnet ist. Eine Anordnung des Gehäuseoberteils 11 erfolgt über entsprechende Hakenelemente 13. Bei Anordnung eines Steckers in der Anschlussbuchse 14 besteht die Gefahr, dass durch die, entlang der Kraftrichtung F wirkende, Druckkraft die Hakenelemente 13 seitlich nach außen weichen, wobei dieses Ausweichen durch die Pfeile P signalisiert ist. Zweckmäßigerweise fixieren bzw. halten aber nun die Verbindungsstellen 30 diese, sodass eine sichere Kraft- und Formschlüssigkeit gewährleistet ist.

Die Verbindungsstellen 30 sind in den Figuren nur skizzenhaft dargestellt. Bevorzugt ist die Leiterplatte 20 vollständig in Leiterplattenlack eingetaucht, wodurch Lücken, Hinterschneidungen etc. zwischen der Leiterplatte 20 und dem jeweiligen Tragelement 10 geschlossen bzw. gefüllt und Verbindungsstellen 30 geformt werden können. Insofern ist z. B., mit Bezug auf die Figur 2, die gesamte Leiterplatte 20, der Pin-Block 22, sowie das Gehäuseunterteil 11, bis hin zur Eintauchtiefe T, mit Leiterplattenlack benetzt. Die Anordnung der Leiterplatte 20 in dem entsprechenden Tragelement 10 kann über ein einfaches Einlegen bzw. Auflegen der Leiterplatte 20 erfolgen. Wie insbesondere aus der Fig. 3 ersichtlich ist, können aber auch entsprechende Schnapp- oder Hakenelemente bzw. allgemein form- und/oder kraftschlüssige Verbindungselemente vorgesehen sein, um zumindest eine Vorfixierung der Leiterplatte 20 gegenüber dem jeweiligen Tragelement 10 zu ermöglichen. Diese Vorfixierung ist insbesondere spannungsfrei ausgebildet und führt nicht zu einem Verzug der Leiterplatte 20.

### Bezugszeichenliste

- 10: Tragelement, Gehäuse, Gehäuseteil, Gehäuseschale
- 11: Gehäuseoberteil
- 12: Gehäuseunterteil
- 13: Hakenelement
- 14: Anschlussbuchse
- 16: Zusatzelement
- 20: Leiterplatte
- 22: Elektronikbaustein, Pin-Block
- 30: Verbindungsstelle
- E: Leiterplatten-Ebene
- T: Eintauchtiefe
- F: Kraftrichtung
- P: Pfeile
- x, y: Richtungen

## Patentansprüche

1. Elektronikmodul,
umfassend ein Tragelement (10) und eine Leiterplatte (20),
wobei die Leiterplatte (20) über eine Vielzahl von Verbindungsstellen (30) in und/oder an dem Tragelement (10) befestigt ist,
wobei die Verbindungsstellen (30) Lücken/Spalte/Hinterschneidungen zwischen dem Tragelement (10) und der Leiterplatte (20) ausfüllen oder schließen, und
wobei die Verbindungsstellen (30) durch ein aushärtbares Medium gebildet sind, und
wobei das aushärtbare Medium Leiterplattenlack ist.

2. Elektronikmodul nach Anspruch 1,
wobei die Verbindungsstellen (30) durch ein zumindest bereichsweises Eintauchen der Leiterplatte (20) und des Tragelements (10) in den Leiterplattenlack gebildet werden.

3. Elektronikmodul nach Anspruch 1 oder 2,
wobei die Leiterplatte (20) in und/oder an das Tragelement (10) formschlüssig angeordnet oder anordenbar, insbesondere an- oder einsteckbar, ist.

4. Elektronikmodul nach einem der vorhergehenden Ansprüche,
wobei das Tragelement (10) zumindest ein Hakenelement (13) aufweist, welches zur form- und/oder kraftschlüssigen Verbindung an der Leiterplatte (20) ausgelegt ist, und
wobei im Bereich der form- und/oder kraftschlüssigen Verbindung zumindest eine Verbindungsstelle (30) vorgesehen ist.

5. Elektronikmodul nach einem der vorhergehenden Ansprüche,
wobei die Leiterplatte (20) zumindest einen Elektronikbaustein (22) umfasst, und
wobei zumindest eine Verbindungsstelle (30) an dem zumindest einen Elektronikbaustein (22) ausgebildet ist.

6. Elektronikmodul nach einem der vorhergehenden Ansprüche,
wobei die Außenabmessungen des Tragelements (10) im Wesentlichen den Außenabmessungen der Leiterplatte (20) entsprechen.

7. Elektronikmodul nach einem der vorhergehenden Ansprüche,
wobei das Tagelement (10) ein Gehäuse oder Gehäuseteil des Elektronikmoduls, insbesondere ein Außengehäuse, ist.

8. Elektronikmodul nach Anspruch 7,
wobei das Gehäuse oder der Gehäuseteil zumindest eine Anschlussbuchse (14) formt/ausbildet.

9. Elektronikmodul nach einem der vorhergehenden Ansprüche,
wobei das Tragelement (10) eine Versteifungsstruktur aufweist, und
wobei die Versteifungsstruktur Streben, Stegen, Waben etc. umfasst, welche sich im Wesentlichen senkrecht zu einer Leiterplattenebene (E) erstrecken.

10. Steuergerät, insbesondere Hauptsteuergerät eines Kraftfahrzeugs, ausgebildet als ein Elektronikmodul nach einem der vorhergehenden Ansprüche, umfassend ein Gehäuse und eine darin angeordnete Leiterplatte (20),
wobei das Gehäuse das Tragelement (10) ist.

11. Verfahren zum Befestigen einer Leiterplatte (20) an einem Tragelement (10), insbesondere einem Gehäuse oder Gehäuseteil,
umfassend die Schritte:
- Bereitstellen einer Leiterplatte (20) und eines Tragelements (10);
- Befestigen der Leiterplatte (20) an dem Tragelement (10) durch eine Vielzahl von Verbindungsstellen (30) und Ausbilden der Verbindungsstellen (30) durch Aufbringen von Leiterplattenlack.

12. Verfahren nach Anspruch 11,
weiter umfassend die Schritte:
- Anordnen, insbesondere spannungsfreies Anordnen, der Leiterplatte (20) in und/oder an dem Tragelement (10);
- Eintauchen der Leiterplatte (20) in den Leiterplattenlack.

13. Verwendung von Leiterplattenlack zum Befestigen einer Leiterplatte (20) an einem Tragelement (10),
wobei die Leiterplatte (20) über eine Vielzahl von Verbindungsstellen (30) in und/oder an dem Tragelement (10) befestigt ist,
wobei die Verbindungsstellen (30) Lücken/Spalte/Hinterschneidungen zwischen dem Tragelement (10) und der Leiterplatte (20) ausfüllen oder schließen, und
wobei die Verbindungsstellen (30) durch den Leiterplattenlack gebildet sind.

## Claims

1. Electronic module
comprising a carrier element (10) and a circuit board (20),
wherein the circuit board (20) is attached in and/or to the carrier element (10) via a plurality of connection sites (30),
wherein the connection sites (30) fill or close voids/gaps/undercuts between the carrier element (10) and the circuit board (20), and
wherein the connection sites (30) are formed by means of a hardenable medium, and
wherein the hardenable medium is circuit board lacquer.

2. Electronic module according to Claim 1,
wherein the connection sites (30) are formed by means of immersing at least in regions the circuit board (20) and the carrier element (10) in the circuit board lacquer.

3. Electronic module according to Claim 1 or 2,
wherein the circuit board (20) is arranged or may be arranged in and/or on the carrier element (10) in a positive locking manner, in particular is plugged on or in said carrier element.

4. Electronic module according to any one of the preceding claims,
wherein the carrier element (10) comprises at least one hook element (13) that is configured so as to be connected to the circuit board (20) in a positive locking and/or non-positive locking manner, and
wherein at least one connection site (30) is provided in the region of the positive locking and/or non-positive locking connection.

5. Electronic module according to any one of the preceding claims,
wherein the circuit board (20) comprises at least one electronic component (22), and
wherein at least one connection site (30) is produced on the at least one electronic component (22).

6. Electronic module according to any one of the preceding claims,
wherein the outer dimensions of the carrier element (10) correspond essentially to the outer dimensions of the circuit board (20).

7. Electronic module according to any one of the preceding claims,
wherein the carrier element (10) is a housing or a housing part of the electronic module, in particular an outer housing.

8. Electronic module according to Claim 7,
wherein the housing or the housing part forms/produces at least one connection socket (14).

9. Electronic module according to any one of the preceding claims,
wherein the carrier element (10) comprises a reinforcing structure, and
wherein the reinforcing structure comprises braces, struts or honey-comb structures etc. that extend essentially perpendicular to a circuit board plane (E).

10. Control unit, in particular master control unit of a motor vehicle,
designed as an electronic module according to any one of the preceding claims, comprising a housing and a circuit board (20) that is arranged in said housing,
wherein the housing is the carrier element (10).

11. Method for attaching a circuit board (20) to a carrier element (10), in particular a housing or housing part,
comprising the steps:
- providing a circuit board (20) and a carrier element (10) ;
- attaching the circuit board (20) to the carrier element (10) by means of a plurality of connection sites (30) and producing the connection sites (30) by means of applying circuit board lacquer.

12. Method according to Claim 11,
further comprising the steps:
- arranging, in particular arranging in a stress-free manner, the circuit board (20) in and/or on the carrier element (10);
- immersing the circuit board (20) in the circuit board lacquer.

13. Use of circuit board lacquer for attaching a circuit board (20) to a carrier element (10),
wherein the circuit board (20) is attached in and/or to the carrier element (10) via a plurality of connection sites (30),
wherein the connection sites (30) fill or close voids/gaps/undercuts between the carrier element (10) and the circuit board (20), and
wherein the connection sites (30) are formed by means of the circuit board lacquer.

## Revendications

1. Module électronique,
comprenant un élément de support (10) et une carte de circuits imprimés (20),
dans lequel la carte de circuits imprimés (20) est fixée dans et/ou sur l'élément de support (10) par l'intermédiaire d'une pluralité de points de jonction (30),
dans lequel les points de jonction (30) comblent ou obturent des espaces/des interstices/des contre-dépouilles entre l'élément de support (10) et la carte de circuits imprimés (20), et
dans lequel les points de jonction (30) sont formés par un milieu durcissable, et
dans lequel le milieu durcissable est un vernis pour carte de circuits imprimés.

2. Module électronique selon la revendication 1, dans lequel les points de jonction (30) sont formés en plongeant au moins par endroits la carte de circuits imprimés (20) et l'élément de support (10) dans le vernis pour carte de circuits imprimés.

3. Module électronique selon la revendication 1 ou 2, dans lequel la carte de circuits imprimés (20) est ou peut être disposée, en particulier connectée ou enfichée, par complémentarité de forme dans et/ou sur l'élément de support (10).

4. Module électronique selon l'une quelconque des revendications précédentes,
dans lequel l'élément de support (10) présente au moins un élément de crochet (13) qui est conçu pour un assemblage par complémentarité de forme et/ou par adhérence sur la carte de circuits imprimés (20), et
dans lequel au moins un point de jonction (30) est prévu au niveau de l'assemblage par complémentarité de forme et/ou par adhérence.

5. Module électronique selon l'une quelconque des revendications précédentes,
dans lequel la carte de circuits imprimés (20) comprend au moins un composant électronique (22), et
dans lequel au moins un point de jonction (30) est réalisé sur ledit au moins un composant électronique (22).

6. Module électronique selon l'une quelconque des revendications précédentes, dans lequel les dimensions extérieures de l'élément de support (10) correspondent substantiellement aux dimensions extérieures de la carte de circuits imprimés (20).

7. Module électronique selon l'une quelconque des revendications précédentes, dans lequel l'élément de support (10) est un boîtier ou une partie de boîtier du module électronique, en particulier un boîtier extérieur.

8. Module électronique selon la revendication 7, dans lequel le boîtier ou la partie de boîtier forme/réalise au moins une prise de raccordement (14).

9. Module électronique selon l'une quelconque des revendications précédentes, dans lequel l'élément de support (10) présente une structure de renfort, et dans lequel la structure de renfort comprend des barres, des entretoises, des alvéoles etc. qui s'étendent de manière substantiellement perpendiculaire à un plan de carte de circuits imprimés (E).

10. Appareil de commande, en particulier appareil de commande principal d'un véhicule automobile, qui est réalisé sous la forme d'un module électronique selon l'une quelconque des revendications précédentes, comprenant un boîtier et une carte de circuits imprimés (20) disposée dans celui-ci, le boîtier étant l'élément de support (10).

11. Procédé permettant de fixer une carte de circuits imprimés (20) à un élément de support (10), en particulier un boîtier ou une partie de boîtier, comprenant les étapes consistant à :
- fournir une carte de circuits imprimés (20) et un élément de support (10) ;
- fixer la carte de circuits imprimés (20) à l'élément de support (10) par l'intermédiaire d'une pluralité de points de jonction (30), et réaliser les points de jonction (30) par l'application d'un vernis pour carte de circuits imprimés.

12. Procédé selon la revendication 11, comprenant en outre les étapes consistant à :
- disposer, en particulier disposer hors tension, la carte de circuits imprimés (20) dans et/ou sur l'élément de support (10) ;
- plonger la carte de circuits imprimés (20) dans le vernis pour carte de circuits imprimés.

13. Utilisation d'un vernis pour carte de circuits imprimés pour fixer une carte de circuits imprimés (20) à un élément de support (10),
dans lequel la carte de circuits imprimés (20) est fixée par l'intermédiaire d'une pluralité de points de jonction (30) dans et/ou sur l'élément de support (10),
dans lequel les points de jonction (30) comblent ou obturent des espaces/des interstices/des contre-dépouilles entre l'élément de support (10) et la carte de circuits imprimés (20), et
dans lequel les points de jonction (30) sont formés par le vernis pour carte de circuits imprimés.
